(19) **Europäisches Patentamt / European Patent Office / Office européen des brevets**

(11) **EP 1 913 695 B1**

(12) **EUROPÄISCHE PATENTSCHRIFT**

(45) Veröffentlichungstag und Bekanntmachung des Hinweises auf die Patenterteilung:
**31.08.2016 Patentblatt 2016/35**

(21) Anmeldenummer: **06764220.7**

(22) Anmeldetag: **19.07.2006**

(51) Int Cl.:
**H03K 19/173** *(2006.01)*

(86) Internationale Anmeldenummer:
**PCT/EP2006/064419**

(87) Internationale Veröffentlichungsnummer:
**WO 2007/014857 (08.02.2007 Gazette 2007/06)**

(54) **BAUELEMENT MIT EINER IN IHRER FUNKTIONALITÄT KONFIGURIERBAREN SCHALTUNGSANORDNUNG**

COMPONENT WITH A FUNCTIONALLY-CONFIGURABLE CIRCUIT ARRANGEMENT

COMPOSANT POURVU D'UN ENSEMBLE CIRCUIT CONFIGURABLE DU POINT DE VUE DE SA FONCTIONNALITE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **01.08.2005 DE 102005036066**

(43) Veröffentlichungstag der Anmeldung:
**23.04.2008 Patentblatt 2008/17**

(73) Patentinhaber: **Siemens Aktiengesellschaft 80333 München (DE)**

(72) Erfinder:
• **BANGERT, Joachim**
**91052 Erlangen (DE)**
• **KÖCHY, Markus**
**30916 Isemhagen (DE)**
• **SIEMERS, Christian**
**38446 Wolfsburg (DE)**

(56) Entgegenhaltungen:
**DE-A- 10 320 701    US-A1- 2005 093 574**

**Beschreibung**

Die Erfindung betrifft ein Bauelement mit einer in ihrer Funktionalität konfigurierbaren Schaltungsanordnung gemäß dem Oberbegriff des Anspruchs 1.

Eine solche Schaltungsanordnung umfasst eine eine Datenleitung spannungsabhängig freigebende oder sperrende erste Schaltgruppe und wenigstens eine zweite, zwei sich durch einen Spannungshub unterscheidende, diskrete Ausgangsspannungen erzeugende Schaltgruppe, deren den diskreten Ausgangsspannungen zugeordnete Schaltzustände nichtflüchtig speicherbar sind, wobei die Sperrung oder Freigabe der Datenleitung durch den Schaltzustand der ersten Schaltgruppe festlegbar ist.

Konfigurierbare Bauelemente sind seit langem bekannt, sie werden, da sie vorzugsweise Logikfunktionen ausführen, allgemein als Programmable Logic Device (PLD) bezeichnet. Solche PLD-Bauelemente werden vornehmlich für weniger komplexe Aufgaben eingesetzt. Derartige Logikbausteine sind z. B. aus der US 4,870,302 oder der Veröffentlichung "Ranmuthu, I.W. et al.; Magneto-resistive elements - An Alternative to Floating Gate Technology; in: Proceedings of the Midwest Symposiums on Circuits and Systems, 1992, pg(s). 134 - 136 vol.1" bekannt. Das Anwendungsprogramm wird bei solchen Logikbausteinen beim Booten definiert: Aus einem Programmspeicher wird ein Programm ausgelesen, konfigurierbare Bereiche werden konfiguriert. Die konfigurierbaren Bereiche haben folgende Eigenschaften: Entweder definieren sie Verknüpfungen zwischen vorgegebenen Punkten (Routing-Bereiche) oder sie definieren die Verarbeitung logischer Eingangssignale zu logischen Ausgangssignalen (Logikzellen-Bereiche).

Die Programmierinformation wird in der Fläche verteilt. Die Konfigurierbarkeit der PLDs beschränkt sich auf wenige konfigurierbare Parameter, die beim Booten fest eingestellt werden. Es werden dabei zwei Speicher benötigt: Ein externer Boot-Speicher-Chip (diskreter Chip, z. B. ein EEPROM 113 in US 4,870,302) und interne, flächig verteilte Speicherzellen (z. B. nach Fig. 3a und 10a in US 4,870,302 oder Fig. 5 in der Veröffentlichung von Ranmuthu at al.). Die lokalen Speicherzellen enthalten nach dem Booten die Informationen für die Verknüpfungen und für die Logikfunktionen der Zellen.

Wesentliche Parameter zur Bewertung der Leistungsfähigkeit dieser Speicher sind der Flächenbedarf und der statische (Leck-)Energieverbrauch als statische "Kosten" sowie die Schaltgeschwindigkeit und -kapazität als dynamische "Kosten". Betrachtet werden nachfolgend nur nichtflüchtige, rekonfigurierbare Architekturen, nämlich SRAM in Kombination mit Boot-ROM öder EEPROM. Das SRAM ist eine relativ große Zelle, besitzt eine schnelle Arbeitsgeschwindigkeit und ist ein flüchtiger Speicher, das Boot-ROM ist dagegen langsam und nicht-flüchtig. Das EEPROM ist eine mittelgroße Zelle mit langsamer Arbeitsgeschwindigkeit, hohem Konfigurierleistungsbedarf und geringem "Lese"-Leistungsverbrauch.

Die Flächen- und die Verlustleistungseffizienz der verteilten Speicherzellen ist ca. bis zu zwei Größenordnungen schlechter als die von diskreten Speicherchips gleicher Leistungsfähigkeit. Benötigt das Anwendungsprogramm aber weniger Leistungsfähigkeit als die Chips bereitstellen, so erzeugen die nicht genutzten Bereiche unvermeidlich ebenfalls Verlustleistung. Typische Ausnutzungsgrade der vorhandenen Logikblocks von PLDs liegen bei ca. 30% bis 70%. Zu einem bestimmten Zeitpunkt sind nur Bruchteile davon aktiv an der Verarbeitung von Logikinformationen beteiligt.

Die über den ganzen Chip verteilten Verknüpfungen können bei herkömmlichen Bauelementen nur durch Boot-Vorgänge gesetzt werden. Eine dynamische Konfiguration der Verknüpfungen könnte den Ausnutzungsgrad erhöhen.

Die DE 103 20 701 A1 schlägt daher vor, nur ein einziges Bauelement zu verwenden, in welches ein schnell schaltbarer, nichtflüchtiger Speicher integriert ist. Konkret werden hierzu TMR-Zellen vorgeschlagen (TMR = tunnel-magneto-resistive). Derartige magnetoresistive Elemente zeichnen sich dadurch aus, dass ihr Widerstandsverhalten durch die Stellung der Magnetisierung einer weichmagnetischen Informationsschicht bezüglich einer hartmagnetischen Referenzschicht bestimmt wird. Je nachdem, ob die Magnetisierungen parallel oder antiparallel zueinander stehen, ist ein niedriger oder hoher Widerstand über das Element realisiert. Die Änderung der Magnetisierungsrichtung der weichmagnetischen Schicht kann auf einfache und schnelle Weise erfolgen, wozu ein über einen Konfigurierleiter geführter Konfigurierstrompuls, der ein auf die Magnetisierung der weichmagnetischen Schicht wirkendes Magnetfeld erzeugt, dient.

Die üblicherweise verfügbaren TMR-Technologien weisen zwischen den beiden diskret schaltbaren Widerständen jedoch nur eine Widerstandsänderung von 50 % auf, das heißt das Verhältnis des kleineren Widerstands zu dem größeren Widerstand liegt bei etwa 2:3. Bedenkt man weiterhin, dass derzeit verfügbare TMR-Elemente maximal etwa 600 mV zerstörungsfrei an Spannung abfallen lassen können, so ist das Widerstandsverhältnis in den meisten Fällen nicht ausreichend, um eine Datenleitung mit den im Stand der Technik beschriebenen Bauelementen zu schalten, da an die zwischen zwei Zuständen mit unterschiedlichen diskreten Widerstandswerten schaltbaren Widerstandselemente nur eine gewisse Maximalspannung anlegbar ist und daher der Spannungshub begrenzt ist.

Der Erfindung liegt daher die Aufgabe zugrunde, ein Bauelement zu schaffen, das trotz Widerstandselementen mit niedrigem Widerstandsverhältnis zum Einsatz als PLD geeignet ist sowie Platz spart und schnelle Schaltzeiten ermöglicht.

Zur Lösung dieser Aufgabe ist eine Schaltungsanordnung mit den Merkmalen des Anspruchs 1 vorgesehen.

Weiterbildungen sind in den Unteransprüchen angegeben.

Gegenstand der Erfindung ist ein Bauelement der eingangs genannten Art, das neben der ersten und zweiten Schaltgruppe eine dritte Schaltgruppe zur Vergrößerung des Spannungshubs zwischen der ersten Schaltgruppe und der zweiten Schaltgruppe enthält.

In dem häufigen Fall, dass der Spannungshub der zweiten Schaltgruppe nicht ausreichend ist, um die Datenleitung hinreichend freizuschalten oder zu sperren, wird vorteilhafterweise durch die zusätzliche, dritte Schaltgruppe erreicht, dass der Spannungshub entsprechend vergrößert wird. Somit kann dann erreicht werden, dass die erste Schaltgruppe entweder vollständig aufgeschaltet ist (minimaler Widerstand) oder vollständig geschlossen ist (maximaler Widerstand). Die Amplitude der durch die Datenleitung gesendeten Signale kann verkleinert werden, da sich geringe Verluste und eine gute Sperrung ergeben.

Die erste Schaltgruppe kann wenigstens ein zwischen zwei Zuständen mit unterschiedlichen diskreten Widerständen schaltbares Widerstandselement, dessen nicht flüchtig speicherbare Schaltzustände den Spannungshub zwischen den zwei diskreten Ausgangsspannungen bestimmen, umfassen. Wenn das Widerstandsverhältnis des oder der Widerstandselemente zu klein ist, um das freigebende oder sperrende Schaltelement direkt anzusteuern, wird durch die weitere Schaltgruppe der Spannungshub erfindungsgemäß vergrößert, mit anderen Worten, das Schaltsignal wird verstärkt.

Dabei ist es in Ausgestaltung der Erfindung vorgesehen, dass die erste Schaltgruppe einen Pass-Transistor umfasst. Wird dieser Transistor gesperrt, wird gleichzeitig auch die Datenleitung gesperrt, sodass keine Informationen übertragen werden können. Durch die erfindungsgemäß erhöhte Ansteuerspannung an den Pass-Transistor weist dieser im anderen Schaltungszustand einen so geringen Widerstand auf, dass Informationen (Signale) fast verlustfrei über die Datenleitung übertragen werden können.

Vorzugsweise kann die zweite Schaltgruppe des erfindungsgemäßen Bauelements als Spannungsteiler ausgebildet sein. Wird in einem solchen, aus zwei Widerständen bestehenden Spannungsteiler einer der Widerstände als zwischen zwei Zuständen mit unterschiedlichen diskreten Widerständen schaltbares Widerstandselement ausgebildet, so hängt die zwischen den beiden Widerständen abgegriffene Spannung vom Schaltzustand des Widerstandselements ab. Mit besonderem Vorteil können zwei solche Widerstandselemente vorgesehen sein, die jeweils gegenläufig angesteuert werden. In einer solchen Ausführungsform lässt sich ein größerer Spannungshub erreichen, indem immer dann, wenn ein Widerstand erhöht wird, der andere erniedrigt wird.

Wird ein solcher Spannungsteiler verwendet, kann idealerweise für die am Spannungsteiler angelegten Spannungen U1 und U2 und an der weiteren Schaltgruppe angelegte Spannungen Ub und 0V die Ungleichung $0V \leq U1 < U2 \leq Ub$ gelten. In der Praxis hat es sich gezeigt, dass in einem solchen Parameterbereich der Spannungshub am ehesten vergrößert werden kann.

Das oder die Widerstandselemente können ein Verhältnis zwischen den zwei diskreten Widerständen von etwa 2:3 aufweisen. Ein solches Verhältnis, das bei herkömmlichen Bauelementen kaum geeignet war, das gewünschte Schaltverhalten zu erzielen, ist im Rahmen der vorliegenden Erfindung vollkommen ausreichend.

Die dritte Schaltgruppe umfasst erfindungsgemäß als Inverter geschaltete n-Kanal- und p-Kanal-Transistoren. Eine solche Inverterschaltung ist ohne Probleme auf kleinem Raum realisierbar und damit Platz sparend in das Bauelement integrierbar. Außerdem bietet sie hervorragende Schalteigenschaften, die somit vorteilhaft zur Verstärkung des Spannungshubes genutzt werden können. Speziell kann die dritte Schaltgruppe auch CMOS-Transistoren umfassen. Dies ist der Fall, wenn gleichartige Transistoren als n-Kanal- und p-Kanal-Transistoren verwendet werden. Auch in diesem Fall können die Fertigungstechniken für solche Transistoren im Rahmen der Erfindung weiter verwendet werden.

Erfindungsgemäß ist das Widerstandselement ein einen magnetoresistiven Effekt zeigendes Element, insbesondere eine TMR-Zelle. TMR-Zellen zeichnen sich insbesondere durch ihre kurzen Schaltzeiten im Bereich von wenigen Nanosekunden aus, üblicherweise sind die Schaltzeiten kleiner als 5 Nanosekunden, oft auch kleiner als 3 Nanosekunden. So sind zum Beispiel auch hochfrequent betriebene, so genannte "Toggle-Schaltungen" im Rahmen der Erfindung möglich. Solche Schaltungen lassen sich beispielsweise verwenden, wenn jedes zweite Signal auf eine andere Art und Weise verarbeitet werden soll als die anderen Signale.

Erfindungsgemäß ist eine zwei Widerstandselemente aufweisende Doppelzelle vorgesehen, bei der zwei Widerstandselemente in Reihe geschaltet sind. Dabei kann die Doppelzelle Platz sparend in gestapelter Bauweise aufgebracht sein. Damit kann an die Widerstandselemente, zum Beispiel die TMR-Zellen, die doppelte Spannung angelegt werden, sodass sich insgesamt schon allein durch diese Bauweise eine Verdoppelung des Spannungshubes ergibt. Ein weiterer Vorteil ergibt sich durch die gestapelte Bauweise. Es wird dabei nicht nur besonders wenig Platz verbraucht, sondern der grundsätzliche Aufbau des Spannungsteilers entspricht dem Aufbau der Basiszelle einer so genannten "look up table (LUT)", in der Eingangssignale mit Referenzsignalen verglichen werden können und entsprechend diesem Vergleich eine logische Ausgabe erfolgt. Damit können für den erfindungsgemäßen Spannungsteiler die von der Basiszelle bekannten Herstellungsverfahren weiter verwendet werden.

Weitere Vorteile und Einzelheiten der Erfindung ergeben sich aus dem im Folgenden beschriebenen Ausführungsbeispiel sowie anhand der Figuren. Dabei zeigen:

Fig. 1     das Schaltdiagramm eines erfindungsgemäßen Bauelements,

Fig. 2     eine Prinzipskizze des Aufbaus und der Verschaltung einer zweiten Schaltgruppe, und

Fig. 3     das Schaltdiagramm zur Prinzipskizze aus Fig. 2.

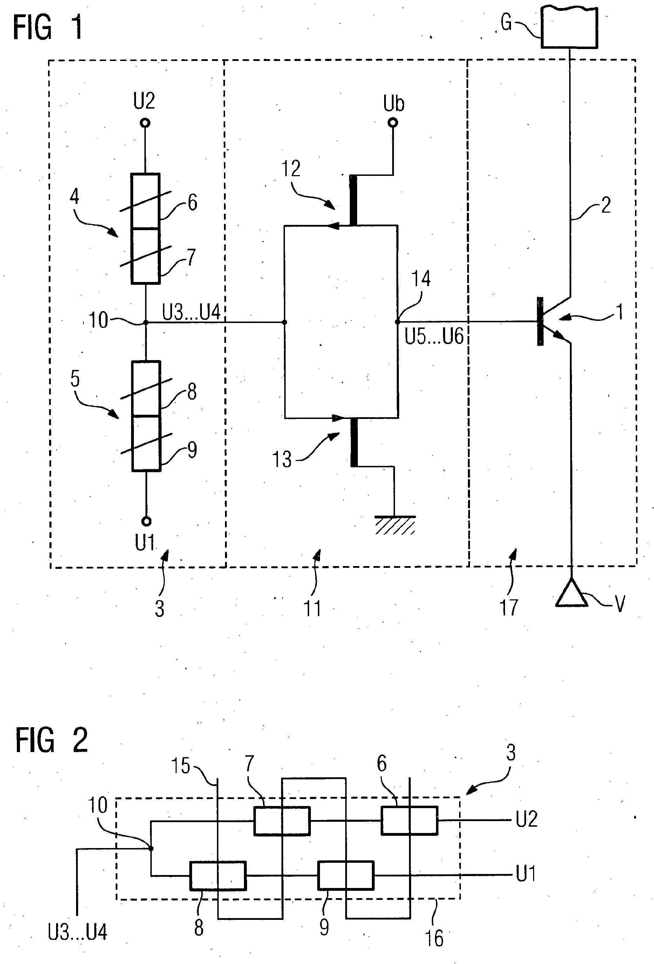

Fig. 1 zeigt das Schaltdiagramm eines Bauelements nach der vorliegenden Erfindung. Dabei soll ein Pass-Transistor 1 einer ersten Schaltgruppe 17 den Signalfluss auf einer Datenleitung 2 entweder freischalten oder sperren, je nach einer in den Widerstandselementen einer zweiten Schaltgruppe 3 gespeicherten Konfiguration. Die Datenleitung 2 kann zum Beispiel einen Verstärker V und ein Gatter G miteinander verknüpfen. Es ist jedoch genauso möglich, einzelne Logikzellen miteinander selektiv zu verbinden oder den Signaltransfer zwischen ihnen zu unterbinden.

Die zweite Schaltgruppe 3, die in ihrer Grundschaltung einen Spannungsteiler darstellt, umfasst zwei Doppelzellen 4 und 5, die jeweils aus zwei in Reihe geschalteten TMR-Zellen 6 und 7 bzw. 8 und 9 bestehen. Der Schaltzustand der zwei TMR-Zellen in jeder Doppelzelle ist immer gleich, und die Doppelzellen 4 und 5 werden invertiert angesteuert, das bedeutet, sie befinden sich immer in entgegengesetzten Schaltzuständen. Weist also die Doppelzelle 4 einen großen Widerstand auf, so ist der Widerstand der Doppelzelle 5 klein. Ist hingegen der Widerstand der Doppelzelle 4 klein geschaltet, so ist der Widerstand der Doppelzelle 5 hoch. Die Spannung am zwischen den Widerständen liegenden Abgriffspunkt 10 ist vom jeweiligen Schaltzustand der Doppelzellen 4 und 5 abhängig und liefert die grundsätzliche Schaltinformation für den Pass-Transistor 1. Ist der Widerstand der Doppelzelle 5 groß, so ist eine große Spannung U3 gegen Masse am Punkt 10 abgreifbar, ist der Widerstand der Doppelzelle 5 niedrig und damit der Widerstand der Doppelzelle 4 hoch, so wird eine niedrigere Spannung U4 abgegriffen. Die Differenz U3-U4 gibt den Spannungshub ΔU an. Da TMR-Zellen verwendet werden, bei denen das Verhältnis zwischen dem niedrigen Widerstand und dem hohen Widerstand im Bereich von etwa 2:3 liegt, reicht der Spannungshub ΔU in den meisten Fällen nicht aus, um den Pass-Transistor 1 unmittelbar von einem vollkommen sperrenden Zustand in einen vollkommen offenen Zustand umzuschalten.

Daher ist zur Vergrößerung des Spannungshubes zwischen der zweiten Schaltgruppe 3 und der ersten Schaltgruppe 17 eine dritte Schaltgruppe 11 vorgesehen. Die weitere Schaltgruppe 11 umfasst zwei in Inverterschaltung geschaltete Transistoren, nämlich einen p-Kanal-Transistor 12 und einen n-Kanal-Transistor 13. Eine solche Inverterschaltung (auch als "NOT"-Schaltung bekannt) hat die Eigenschaft, dass entweder nur der Transistor 12 oder nur der Transistor 13 offen sein kann. Bei geeigneter Wahl der Spannung Ub wird also eine Verstärkung des Spannungshubes erreicht, das bedeutet, die Differenz der je nach Schaltzustand am Punkt 14 abgreifbaren Spannungen ΔU'=U5-U6 ist größer als der Spannungshub ΔU=U3-U4. Der verstärkte Spannungshub ΔU' ist aber geeignet, den Pass-Transistor 1 mit dem gewünschten Schaltverhalten zu schalten.

Dadurch, dass die Spannungen U3 und U4 geeignet sind, jeweils einen der Transistoren 12 oder 13 komplett zu schließen und den jeweils anderen komplett zu öffnen, wird die in der dritten Schaltgruppe 11 auftretende Verlustleistung minimiert. Die Transistoren 12 und 13 sind gleichartig, es handelt sich um einen CMOS-Transistor.

Die konkreten Werte für die angelegten Spannungen U1, U2 und Ub ergeben sich aus Materialien und Art der·im Bauelement verwendeten TMR-Zellen und Transistoren. Allgemein gilt jedoch die Ungleichung

$$\text{Masse} = 0 \text{ V} \le \text{U1} < \text{U2} \le \text{Ub}$$

Im vorliegenden Ausführungsbeispiel weisen die TMR-Zellen ein Widerstandsverhältnis von 2:3 auf und es konnten als ideale Werte für die Spannungen Ub=1,5 V, U1=0,15 V, U2=1,35 V bestimmt werden. Damit werden am Punkt 10 die Spannungen U3=0,45 V und U4=1,05 V erreicht, aus denen ein Spannungshub von 0,6 V folgt. Dieser reicht zum vollständigen Schalten der Transistoren 12 und 13 aus. Damit ergibt sich für die Spannungen U5 und U6 im Idealfall ein Wert von 1,5 bzw. 0 V, sodass der Spannungshub ΔU'=1,5 V beträgt. Dieser ist dann ausreichend zur Schaltung des Pass-Transistors 1.

Die hohe Differenz zwischen U2 und U1 von 1,2 V kann lediglich durch die Doppelzellen 5 und 4 erreicht werden. Normalerweise kann an einer TMR-Zelle maximal eine Spannung von 600 mV zerstörungsfrei angelegt werden. Die Verwendung der Doppelzellen 4 und 5 ermöglicht damit schon grundsätzlich eine Verdopplung dieser anlegbaren Spannung.

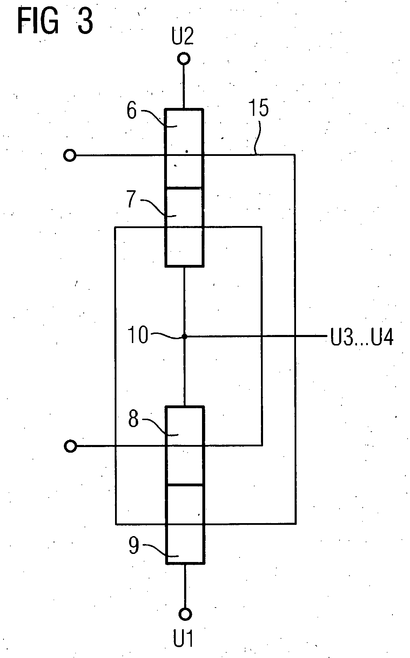

Fig. 2 zeigt den prinzipiellen Aufbau und die Ansteuerung der zweiten Schaltgruppe 3 aus Fig. 1, zum besseren Vergleich zeigt Fig. 3 das zugehörige, in Fig. 1 einpassbare Schaltbild. In Fig. 2 liegen rechts jeweils die Spannungen U2 und U1 an, links wird je nach Schaltzustand die Spannung U3 oder U4 abgegriffen. In Reihe geschaltet sind jeweils die TMR-Zellen 6 und 7 bzw. 8 und 9. Die Datenleitung 15 bildet die Schaltleitung für die TMR-Zellen. Wie aus dem Verlauf der Leitung 15 ersichtlich ist, erhalten die Zellen 6 und 7 jeweils das invertierte Schaltsignal im Vergleich zu den Zellen 8 und 9. Da die Stromrichtung entgegengesetzt ist, weist auch das durch den Strom erzeugte Schaltfeld jeweils in eine andere Richtung, die weichmagnetischen Lagen werden entsprechend dieser Feldrichtung geschaltet. Durch die gestrichelte Umrandung 16 ist der Bereich gekennzeichnet, dessen Aufbau und Fertigungsverfahren aus dem Bereich der Basiszellen schon bekannt ist. In einer Basiszelle, dem Grundbaustein eines look up table (LUT), werden zwei Eingabewerte mit zwei Referenzwerten verglichen, als Ausgabewert erhält man ein von den Eingabewerten abhängiges Signal. Dieser Aufbau kann beibehalten werden, es muss nur die Schaltleitung 15 in den außerhalb der Umrandung 16 liegenden Bereichen wie angegeben weitergeführt werden. Durch den so kompatiblen Aufbau können sowohl die PLD-Zellen als auch die Basiszellen im selben Produktionsschritt beispielsweise auf einen Chip oder eine Platine aufgebracht werden.

**Patentansprüche**

1. Bauelement mit einer in ihrer Funktionalität konfigurierbaren Schaltungsanordnung, mit einer ersten TMR-Doppelzelle (4) und einer zweiten, in Reihe zu der ersten TMR-Doppelzelle (4) geschalteten TMR-Doppelzelle (5), wobei eine TMR-Doppelzelle (4, 5) in einem ersten Schaltzustand einen hohen Widerstand und in einem zweiten Schaltzustand einen niedrigen Widerstand aufweist und beide TMR-Doppelzellen (4, 5) sich in entgegengesetzten Schaltzuständen befinde, wobei den beiden Schaltzuständen der TMR-Doppelzellen (4, 5) sich durch einen Spannungshub unterscheidende diskrete Ausgangsspannungen zugeordnet sind und die Schaltungsanordnung einen eine Datenleitung (2) in Abhängigkeit der Ausgangsspannung sperrenden oder freigebenden Pass-Transistor (1) aufweist, **dadurch gekennzeichnet, dass** zwischen den TMR-Doppelzellen (4, 5) und dem Pass-Transistor (1) ein einen p-Kanal-Transistor (12) und einen n-Kanal-Transistor (13) aufweisender Inverter zum Vergrößern des Spannungshubs angeordnet ist.

2. Bauelement nach Anspruch 1, **dadurch gekennzeichnet, dass** die TMR-Doppelzellen (4, 5) jeweils zwei zwischen zwei Zuständen mit unterschiedlichen diskreten Widerständen schaltbare TMR-Zellen (6, 7, 8, 9), deren nichtflüchtig speicherbare Schaltzustände den Spannungshub zwischen den zwei diskreten Ausgangsspannungen bestimmen, umfasst.

3. Bauelement nach Anspruch 2, **dadurch gekennzeichnet, dass** die TMR-Doppelzellen (4, 5) einen Spannungsteiler bilden.

4. Bauelement nach Anspruch 2 oder 3, **dadurch gekennzeichnet**, dasses jeweils zwei gegenläufig ansteuerbare TMR-Zellen (6, 7, 8, 9) aufweist.

5. Bauelement nach Anspruch 3 oder 4, **dadurch gekennzeichnet, dass** für die am Spannungsteiler angelegten Spannungen U1 und U2 und an dem Inverter angelegte Spannungen Ub und 0V die Ungleichung 0V<=U1<U2<=Ub gilt.

6. Bauelement nach einem Ansprüche 2 bis 6, **dadurch gekennzeichnet, dass** die TMR-Zellen (6, 7, 8, 9) ein Verhältnis zwischen den zwei diskreten Widerständen von im Wesentlichen 2:3 aufweisen.

7. Bauelement nach einem der vorangehenden Ansprüche, **dadurch gekennzeichnet, dass** der Inverter CMOS-Transistoren umfasst.

8. Bauelement nach einem der Ansprüche 2 bis 9, **dadurch gekennzeichnet, dass** die TMR-Zelle (6, 7, 8, 9) eine einen magnetoresistiven Effekt zeigende TMR-Zelle (6, 7, 8, 9), ist.

9. Bauelement nach einem der vorangehenden Ansprüche, **dadurch gekennzeichnet, dass** die TMR-Doppelzelle (4, 5) in gestapelter Bauweise aufgebracht ist.

10. Bauelement nach einem der vorangehenden Ansprüche, **dadurch gekennzeichnet, dass** es gemeinsam mit Basiszellen eines look up table herstellbar ist.

**Claims**

1. Component having a configurable-functionality circuit arrangement, having a first TMR dual cell (4) and a second TMR dual cell (5), which is connected in series with the first TMR dual cell (4), wherein a TMR dual cell (4, 5) has a high resistance in a first switching state and a low resistance in a second switching state, and both TMR dual cells (4, 5) are in opposite switching states, wherein the two switching states of the TMR dual cells (4, 5) have associated discrete output voltages differing in terms of a voltage swing, and the circuit arrangement has a pass transistor (1) that disables or enables a data line (2) on the basis of the output voltage, **characterized in that** an inverter having a p-channel transistor (12) and an n-channel transistor (13) is arranged between the TMR dual cells (4, 5) and the pass transistor (1) for the purpose of increasing the magnitude of the voltage swing.

2. Component according to Claim 1, **characterized in that** the TMR dual cells (4, 5) each comprise two TMR cells (6, 7, 8, 9) that can be switched between two states having different discrete resistances and whose switching states, which can be stored on a nonvolatile basis, determine the voltage swing between the two discrete output voltages.

3. Component according to Claim 2, **characterized in**

**that** the TMR dual cells (4, 5) form a voltage divider.

4. Component according to Claim 2 or 3, **characterized in that** it has two TMR cells (6, 7, 8, 9) that are respectively actuable in opposite directions.

5. Component according to Claim 3 or 4, **characterized in that** the inequality 0V<=U1<U2<=Ub applies for the voltages U1 and U2 applied to the voltage divider and voltages Ub and 0V applied to the inverter.

6. Component according to one of Claims 2 to 6, **characterized in that** the TMR cells (6, 7, 8, 9) have a ratio between the two discrete resistances of essentially 2:3.

7. Component according to one of the preceding claims, **characterized in that** the inverter comprises CMOS transistors.

8. Component according to one of Claims 2 to 9, **characterized in that** the TMR cell (6, 7, 8, 9) is a TMR cell (6, 7, 8, 9) that exhibits a magnetoresistive effect.

9. Component according to one of the preceding claims, **characterized in that** the TMR dual cell (4, 5) is mounted in a stacked design.

10. Component according to one of the preceding claims, **characterized in that** it is manufacturable together with base cells from a lookup table.

**Revendications**

1. Composant avec un agencement de circuit à fonctionnalité configurable, avec une première cellule TMR double (4) et une deuxième cellule TMR double (5) connectée en série à la première cellule TMR double (4), une cellule TMR double (4, 5) présentant dans un premier état de commutation une résistance élevée et dans un deuxième état de commutation une résistance basse, et les deux cellules TMR doubles (4, 5) se trouvant dans des états de commutation opposés, des tensions de sortie discrètes différenciées par une excursion de tension étant associées aux deux états de commutation des cellules TMR doubles (4, 5), et l'agencement de circuit comprenant un transistorballast (1) bloquant ou libérant une ligne de données (2) en fonction de la tension de sortie, **caractérisé en ce qu'**entre les cellules TMR doubles (4, 5) et le transistor-ballast (1) est disposé un inverseur comprenant un transistor à canal p (12) et un transistor à canal n (13) pour l'augmentation de l'excursion de tension.

2. Composant selon la revendication 1, **caractérisé en ce que** les cellules TMR doubles (4, 5) comprennent chacune deux cellules TMR (6, 7, 8, 9) commutables entre deux états avec des résistances discrètes différentes, dont les états de commutation à mémoire non volatile déterminent l'excursion de tension entre les deux tensions de sortie discrètes.

3. Composant selon la revendication 2, **caractérisé en ce que** les cellules TMR doubles (4, 5) constituent un diviseur de tension.

4. Composant selon la revendication 2 ou 3, **caractérisé en ce qu'**il comprend pour chacun deux cellules TMR (6, 7, 8, 9) de sens opposés pouvant être commandées.

5. Composant selon la revendication 3 ou 4, **caractérisé en ce que** pour les tensions U1 et U2 appliquées au diviseur de tension et pour les tensions Ub et 0V appliquées à l'inverseur, on observe l'inégalité 0V <= U1 < U2 <= Ub.

6. Composant selon l'une des revendications 2 à 6, **caractérisé en ce que** les cellules TMR (6, 7, 8, 9) présentent un rapport entre leurs deux résistances discrètes de sensiblement 2/3.

7. Composant selon l'une des revendications précédentes, **caractérisé en ce que** l'inverseur comprend des transistors CMOS.

8. Composant selon l'une des revendications 2 à 9, **caractérisé en ce que** la cellule TMR (6, 7, 8, 9) est une cellule TMR (6, 7, 8, 9) montrant un effet magnéto-résistif.

9. Composant selon l'une des revendications précédentes, **caractérisé en ce que** la cellule TMR double (4, 5) est montée en structure empilée.

10. Composant selon l'une des revendications précédentes, **caractérisé en ce qu'**une table de conversion peut être produite en commun avec des cellules de base.

FIG 1

U2

4

6

7

U3...U4

10

U1

5

8

9

12

Ub

14

U5...U6

13

3

11

G

2

1

17

V

FIG 2

15

7

6

3

10

U2

U3...U4

8

9

16

U1

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4870302 A

- DE 10320701 A1

**In der Beschreibung aufgeführte Nicht-Patentliteratur**

- **RANMUTHU, I.W. et al.** Magneto-resistive elements - An Alternative to Floating Gate Technology. *Proceedings of the Midwest Symposiums on Circuits and Systems,* 1992, vol. 1, 134-136